# EUROPEAN PATENT APPLICATION

(11) **EP 4 610 776 A1**
(43) Date of publication of application: **03.09.2025**
(21) Application number: 23887625.4
(22) Date of filing: 07.09.2023
(51) Int. Cl.: G06F 1/18, G06F 1/20

(54) **SERVER**

(30) Priority: 08.11.2022 CN 202211395979
(71) Applicant: xFusion Digital Technologies Co., Ltd., Zhengzhou, Henan 450046 (CN)
(72) Inventor: LI, Zhixin, Zhengzhou, Henan 450046 (CN)
(74) Representative: MERH-IP Matias Erny Reichl Hoffmann Patentanwälte PartG mbB
(86) International application number: PCT/CN2023/117462
(87) International publication number: WO 2024/098931

(57) **Abstract**

Embodiments of the present application provide a server, which relates to the field of computer servers. The server includes: a chassis, a system board, and at least one storage module. The chassis includes an opening. The chassis includes a first accommodation space and a second accommodation space, and the first accommodation space is closer to the opening relative to the second accommodation space. The system board is located in the second accommodation space. The storage module includes a push-pull bracket, a storage board, and a plurality of storage devices. The storage board is secured in the push-pull bracket, and is electrically connected to the system board. The plurality of storage devices are disposed on opposite sides of the storage board, and are pluggably connected to the storage board. The storage module is slidably connected to the chassis by the push-pull bracket, to enable the storage module to be pushed into the first accommodation space through the opening. More storage devices may be placed in the chassis of the server provided in the embodiments of the present application, which is conducive to achieving high density of the server.

## Description

This application claims priority to Chinese Patent Application No. 202211395979.8 filed with the China National Intellectual Property Administration on November 08, 2022, entitled "SERVER", which is incorporated herein by reference in its entirety.

### TECHNICAL FIELD

The present application relates to the field of computer servers, and in particular to a server.

### BACKGROUND

With the development of Internet technology and big data fields in recent years, the demand for server storage has been increasing, and a storage capacity requirement for a single server is getting higher.

In a conventional high-density storage server, due to factors such as a design and a layout of components in a server chassis, a quantity of drives housed in the server is limited, and a growing demand for a large storage capacity cannot be satisfied.

### SUMMARY

Embodiments of the present application aim to provide a server, which is used for increasing a quantity of storage devices that can be placed in a server chassis to achieve a high-density server, and relate to the field of computer servers.

To achieve the purpose, the embodiments of the present application provide the following technical solutions.

In a first aspect, a server is provided in the embodiments of the present application. The server includes: a chassis, a system board, and at least one storage module. The chassis includes an opening. The chassis includes a first accommodation space and a second accommodation space, and the first accommodation space is closer to the opening relative to the second accommodation space. The system board is located in the second accommodation space. The storage module includes a push-pull bracket, a storage board, and a plurality of storage devices. The storage board is secured in the push-pull bracket, and is electrically connected to the system board. The plurality of storage devices are disposed on opposite sides of the storage board, and are pluggably connected to the storage board. The storage module is slidably connected to the chassis by the push-pull bracket, to enable the storage module to be pushed into the first accommodation space through the opening.

In some embodiments of the present application, the server may be provided with at least one storage module. In each storage module, the storage board may be disposed in the middle of the push-pull bracket, so that the plurality of storage devices are disposed on opposite sides of the storage board, and the plurality of storage devices are pluggably connected to the storage board. Therefore, insertion directions of the storage devices in the push-pull bracket can be increased, so that the push-pull bracket of the server is available on both sides on the premise of an unchanged specification in a unit space. This, in turn, allows for more space inside the chassis to accommodate the storage devices, thereby achieving a high-density storage server. In addition, when the storage devices need to be maintained, the push-pull bracket can be directly pulled out of the chassis in the Y-axis direction, and then the storage devices can be directly taken out in the X-axis direction for maintenance. After the maintenance is completed, the push-pull bracket is pushed into the chassis, which facilitates directly plugging the storage devices, thereby improving maintenance efficiency of the server by the staff.

In some embodiments, the push-pull bracket includes a support plate and a cage, and the cage is located on one side of the support plate. The cage includes a mounting position, and the storage board is mounted in the mounting position. The cage also includes a plurality of plugging slots; the plurality of plugging slots are disposed on opposite sides of the mounting position, to enable the storage devices to be plugged into the plugging slots and electrically connected to the storage board.

With this configuration, the storage board is mounted in the mounting position. That is, the storage board is mounted in the cage. Furthermore, space on both sides of the storage board in the cage may be used for placing the storage devices. Based on this, the plurality of storage devices may be disposed on opposite sides of the storage board. Furthermore, the storage devices may be plugged into the plugging slots and electrically connected to the storage board in different directions, so that plugging directions of the storage devices in the push-pull bracket may be increased, and the push-pull bracket of the server is available on both sides on the premise of an unchanged specification in a unit space. This, in turn, allows for more space inside the chassis to accommodate the storage devices, thereby achieving a high-density storage server.

In some embodiments, the push-pull bracket also includes a slide rail assembly. The slide rail assembly is located between one side surface of the support plate facing away from the cage and the chassis.

With this configuration, the slide rail assembly can be used to realize the push-pull bracket to reciprocate in the Y-axis direction in the chassis. When the server is in a normal operating condition, the slide rail assembly is used to place the push-pull bracket in the first accommodation space in the chassis. However, when the storage devices in the server need to be maintained, the push-pull bracket may be pulled out of the chassis by using the slide rail assembly, and then the storage devices on the push-pull bracket can be pulled out in the Y-axis direction for maintenance of the storage devices, thereby improving maintenance efficiency of the server by the staff.

In some embodiments, the slide rail assembly includes at least one telescopic slide rail. The telescopic slide rail includes a first fixed slide rail, a connecting slide rail, and a second fixed slide rail. One side of the first fixed slide rail is fixedly connected to the chassis, and the other side of the first fixed slide rail is slidably connected to the connecting slide rail. The first fixed slide rail is provided with a first limiting structure on both ends thereof configured to prevent the connecting slide rail from detaching. One side of the second fixed slide rail is fixedly connected to the support plate, and the other side of the second fixed slide rail is slidably connected to the connecting slide rail. The second fixed slide rail is provided with a second limiting structure on both ends thereof configured to prevent the connecting slide rail from detaching.

With this configuration, the first fixed slide rail of the telescopic slide rail is fixedly connected to the chassis, and the second fixed slide rail of the telescopic slide rail is fixedly connected to the support plate. The support plate can be driven to slide in the chassis through relative movement of the first fixed slide rail and the second fixed slide rail, so that the storage module slides in the chassis by the push-pull bracket, and the storage module can be pushed into the first accommodation space through the opening. Based on this, friction when the push-pull bracket slides in the chassis can be reduced, which allows the push-pull bracket to be pulled out of the chassis in the Y-axis direction and the storage devices to be directly taken out in the X-axis direction for maintenance of the storage devices. That is, it is more convenient to perform plugging operations on the storage devices, thereby improving the maintenance efficiency of the server by the staff.

In some embodiments, there are a plurality of the storage modules, and the plurality of storage modules are arranged in a first direction. The first direction is parallel to plugging directions of the storage devices. A first air flow gap is formed between two adjacent storage modules.

With this configuration, cool air flowing through the first air flow gap can respectively enter two storage modules adjacent to the first air flow gap, to dissipate heat from each storage device in the two storage modules. Since the cool air directly acts on each storage device without being affected by temperature of other storage devices, it helps improve a heat dissipation effect of the cool air on each storage device, thereby enhancing a heat dissipation effect and heat dissipation efficiency of the server.

In some embodiments, a width of the first air flow gap in the first direction is greater than or equal to 4 mm.

This configuration ensures that the width of the first air flow gap is not too small, which allows sufficient cool air to flow through the first air flow gap and dissipate heat from each adjacent storage device, thereby enhancing a heat dissipation effect of the cool air on each storage device.

In some embodiments, the width of the first air flow gap in the first direction is less than or equal to 12 mm.

This configuration ensures that the width of the first air flow gap is not too large, and internal space of the chassis occupied by the first air flow gap is not too large, which can meet the demand for space in the chassis for placing a plurality of storage devices.

In some embodiments, in the first direction, a second air flow gap is included between the storage module and the chassis. The first direction is parallel to plugging directions of the storage devices.

With this configuration, the cool air flows through the second air flow gap and enters each adjacent memory module of the second air flow gap, to dissipate heat from each storage device. Since the cool air directly acts on each storage device without being affected by the temperature of other storage devices, it helps improve the heat dissipation effect of the cool air on each storage device, thereby enhancing the heat dissipation effect and the heat dissipation efficiency of the server.

In some embodiments, a width of the second air flow gap in the first direction is greater than or equal to 4 mm.

This configuration ensures that the width of the second air flow gap is not too small, which allows sufficient cool air to flow through the second air flow gap and dissipate heat from the adjacent storage devices, thereby enhancing the heat dissipation effect of the cool air on each storage device.

In some embodiments, the width of the second air flow gap in the first direction is less than or equal to 6 mm.

This configuration ensures that the width of the second air flow gap is not too large, and internal space of the chassis occupied by the second air flow gap is not too large, which can meet the demand for space in the chassis for placing the plurality of storage devices in the chassis.

In some embodiments, along a push-pull direction of the storage module, the chassis includes a side plate opposite to the opening. The side plate includes a plurality of heat dissipation holes.

With this configuration, the cool air enters the server through the opening. After the cool air dissipates heat from the storage devices in the server, temperature of the cool air rises. The heated cool air can flow out of a heat dissipation hole T. Based on this, heat dissipation of each storage device in the server is completed.

In some embodiments, the server also includes a cable. One end of the cable is electrically connected to the system board, and the other end of the cable is electrically connected to the storage board. The chassis also includes a third accommodation space. The third accommodation space is located between the first accommodation space and the second accommodation space. The third accommodation space is used for storing the cable.

With this configuration, when the push-pull bracket is pushed toward a direction facing away from the system board, the cable can extend from the third accommodation space to the first accommodation space, ensuring that when the push-pull bracket is pulled out of the chassis, the system board and the storage board can still maintain an electrical connection. When the push-pull bracket is pushed toward a direction close to the system board, the cable can retract into the third accommodation space and be stored in the third accommodation space. This ensures that storage space of the system board located in the second accommodation space and storage space of the storage module located in the first accommodation space are not affected. Furthermore, the push-pull bracket can slide more flexibly in the chassis.

### BRIEF DESCRIPTION OF DRAWINGS

FIG. 1 is a structural diagram of a server according to some embodiments of the present application;
FIG. 2 is a structural diagram of a server according to other embodiments of the present application;
FIG. 3 is a top view of a server according to some embodiments of the present application;
FIG. 4 is a structural diagram of a heat dissipation module in FIG. 2;
FIG. 5 is an assembly diagram of a slide rail assembly and a chassis in FIG. 3;
FIG. 6 is a structural diagram of a telescopic slide rail in the slide rail assembly in FIG. 3; and
FIG. 7 is a structural diagram of a server according to yet other embodiments of the present application.

### DESCRIPTION OF EMBODIMENTS

The following clearly and completely describes technical solutions in embodiments of the present disclosure in combination with accompanying drawings. Apparently, the described embodiments are some but not all of the embodiments of the present disclosure. All other embodiments obtained by those skilled in the art based on the embodiments provided in the present disclosure fall within the scope of protection of the present disclosure.

Unless otherwise specified in the context, in the entire specification and claims, the terms "comprise" and its other forms, such as a singular form in third personal "comprises" and the present participle form "comprising", are to be interpreted in an open, inclusive sense, that is, "including but not limited to". In the description of the specification, terms such as "one embodiment", "some embodiments", "exemplary embodiments", "example", "specific example", or "some examples" are intended to indicate that specific features, structures, materials, or characteristics related to the embodiment or example are included in at least one embodiment or example of the present disclosure. The schematic representation of the above terms does not necessarily refer to the same embodiment or example. In addition, specific features, structures, materials, or characteristics may be included in one or more embodiments or examples in any suitable manner.

In the embodiments of the present application, terms "first" and "second" are used only for descriptive purposes, and should not be interpreted as indicating or implying relative importance or implicitly specifying a quantity of technical features indicated. Thus, features defined by "first" and "second" may explicitly or implicitly include one or more of such features. Unless otherwise specified in the description of embodiments of the present disclosure, "a plurality of" represents two or more.

When some embodiments are described, terms "coupled" and "connected", along with their derivatives, may be used. For example, the term "coupled" may be used to indicate that two or more components are in direct physical contact or electrical contact with each other when some embodiments are described. For another example, the term "coupled" may be used to indicate that two or more components are in direct physical contact or electrical contact with each other. However, the term "coupled" or "communicatively coupled" may also refer to two or more components that are not in direct contact with each other but still collaborate or interact with each other. The embodiments disclosed are not necessarily limited to the content of the context.

The terms "component", "module", "system", etc. used in the specification are intended to represent computer-related entities, hardware, firmware, a combination of hardware and software, software, or executing software. For example, the component may be, but is not limited to, a process running on a processor, the processor, an object, an executable file, an execution thread, a program, and/or a computer. As shown in the figures, both an application running on a computing device and the computing device may be components. One or more components may reside in a process and/or execution thread, and the components may be located on a single computer and/or distributed between two or more computers. In addition, these components may execute from various computer readable media with various data structures stored thereon. The components may communicate through a local and/or remote process such as based on signals with one or more data packets (for example, data from two components that interact with other components in a local system, distributed system, and/or across a network, such as the Internet, where communication with other systems occurs through signals).

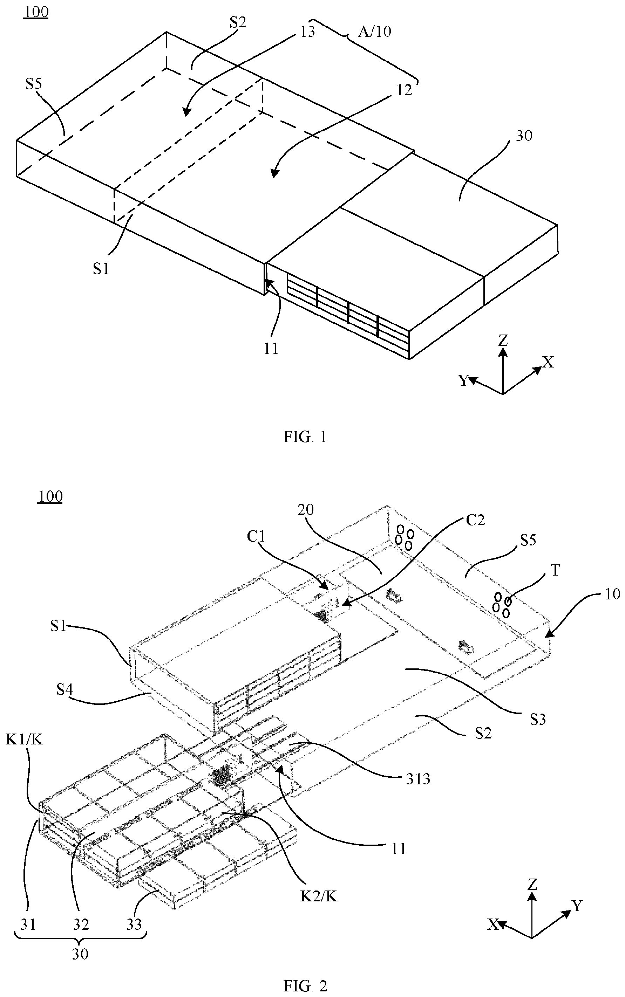

FIG. 1 is a structural diagram of a server according to some embodiments of the present application. FIG. 2 is a structural diagram of a server according to other embodiments of the present application. It may be understood that FIG. 1 and other relevant accompanying drawings only schematically show some of components included in the server 100, and actual shapes, actual sizes, actual locations, and actual structures of these components are not limited in FIG. 1 and the other accompanying drawings.

Embodiments of the present application provide a server. As shown in FIG. 1, and in combination with FIG. 2, the server 100 includes: a chassis 10, a system board 20, and at least one storage module 30.

In an embodiment shown in FIG. 1, the server 100 is in a cubic shape. For convenience of description of the following embodiments, an XYZ coordinate system is established. Specifically, a width direction of the server 100 is defined as the X-axis direction, a length direction of the server 100 as the Y-axis direction, and a height direction of the server 100 as the Z-axis direction. It is understandable that the coordinate system of the server 100 may be flexibly configured according to actual needs, which is not specifically limited here.

The chassis 10 includes an opening 11. The chassis 10 includes a first accommodation space 12 and a second accommodation space 13, and the first accommodation space is closer to the opening 11 relative to the second accommodation space 13.

In some examples, as shown in FIGS. 1 and 2, the chassis 10 includes a first side plate S1 and a second side plate S2 arranged opposite to each other in the X-axis direction, and the chassis 10 also includes a top plate S3 and a bottom plate S4 arranged opposite to each other in the Z-axis direction. And, the chassis 10 also includes a third side plate S5. In the Y-axis direction, the third side plate S5 is disposed opposite to the opening 11, and the first side plate S1, the second side plate S2, the top plate S3, and the bottom plate S4 are circumferentially disposed around the third side plate S5, and the first side plate S1, the second side plate S2, the top plate S3, and the bottom plate S4 are fixedly connected to the third side plate S5. An accommodation space A is formed by the first side plate S1, the second side plate S2, the top plate S3, the bottom plate S4, and the third side plate S5. In the Y-axis direction, the accommodation space A includes a first accommodation space 12 and a second accommodation space 13, and the first accommodation space is farther from the third side plate S5 relative to the second accommodation space 13.

Furthermore, the other side edges of the first side plate S1, the second side plate S2, the top plate S3, and the bottom plate S4 are connected to each other without configuring a side plate, to form the opening 11 of the chassis 10. In this way, an external object can be pushed into the accommodation space A through the opening 11. The first accommodation space is farther from the third side plate S5 relative to the second accommodation space 13. That is, the first accommodation space is closer to the opening 11 relative to the second accommodation space 13.

The system board 20 is located in the second accommodation space 13. That is, the system board 20 may be configured on one side of the chassis 10 away from the opening 11.

In some examples, the system board 20 may be connected to the bottom plate S4 of the chassis 10, to fix the system board 20, which prevents problems such as displacement of the system board 20. In some embodiments of the present application, a connection method between the system board 20 and the bottom plate S4 is not limited, which may be soldering or other connection methods.

As shown in FIG. 2, the storage module 30 in the server 100 includes a push-pull bracket 31, a storage board 32, and a plurality of storage devices 33. The storage module 30 is slidably connected to the chassis 10 by the push-pull bracket 31, to enable the storage module 30 to be pushed into the first accommodation space 12 through the opening 11.

That is, the push-pull bracket 31 may reciprocate in the Y-axis direction in the chassis 10. The push-pull bracket 31 may be pulled from the first accommodation space 12 to the exterior of the chassis 10 in a direction from the third side wall S5 toward the opening 11. Also, the push-pull bracket 31 may be pushed from the exterior of the chassis 10 to the first accommodation space 12 in a direction from the opening 11 toward the third side plate S5.

FIG. 1 only takes the server 100 including two storage modules 30 arranged in the X-axis direction for example. However, some embodiments of the present application do not limit a quantity of the storage modules 30 in the server 100. For example, the server 100 may include 3, 4, or 5 storage modules 30 arranged along the X-axis.

In some examples, the push-pull bracket 31 is located in the first accommodation space 12. In other words, the push-pull bracket 31 is disposed on one side of the system board 20 close to the opening 11, to avoid an obstruction is disposed on the push-pull bracket 31 and the opening 11. This allows for free movement of the push-pull bracket 31 in the Y-axis direction.

In some examples, the push-pull bracket 31 may be configured as a drawer structure. A plurality of storage devices 33 may be placed in the push-pull bracket 31. The push-pull bracket 31 in the server 100 may be pulled out in the Y-axis direction, which facilitates picking and placement of the storage devices 33 stored in the push-pull bracket 31 at any time.

Based on this, in a normal operating state of the server 100, the push-pull bracket 31 may be placed in the first accommodation space 12 of the chassis 10. When the storage devices 33 in the server 100 need to be maintained, the push-pull bracket 31 may be pulled out of the chassis 10 (the push-pull bracket 31 may be pulled from the first accommodation space 12 to the exterior of the chassis 10 along a direction from the third side plate S5 toward the opening 11), and then the storage devices 33 on the push-pull bracket 31 may be taken out in the Y-axis direction for maintenance of the storage devices 33, thereby improving the maintenance efficiency of the server by the staff. After online maintenance of the storage devices 33 is completed, the push-pull bracket 31 may be pushed into the chassis 10 (along a direction from the opening 11 toward the third side plate S5, the push-pull bracket 31 is pushed from the exterior of the chassis 10 to the first accommodation space 12), so that the plurality of storage devices 33 on the push-pull bracket 31 are stored in the chassis 10.

The storage board 32 may be secured in the push-pull bracket 31. The storage board 32 is electrically connected to the system board 20, enabling signal transmission between the storage board 32 and the system board 20. And, the storage board 32 is electrically connected to the plurality of storage devices 33, enabling signal transmission between the storage devices 33 and the storage board 32.

In some examples, the storage devices 33 are drives, and the storage board 32 is a drive backplane. The drive backplane is electrically connected to the system board 20, and the drives are electrically connected to the drive backplane, enabling signal transmission among the drives, the drive backplane, and the system board 20.

In some examples, the plurality of storage devices 33 are disposed in the push-pull bracket 31, and are pluggably connected to the storage board 32. In this way, the plurality of storage devices 33 may transmit signals to and from the storage board 32.

In some examples, the storage board 32 may be a double-sided storage board. In the X-axis direction, the storage board 32 includes a first side surface C1 and a second side surface C2 that are disposed opposite to each other. The first side surface C1 is closer to the first side plate S1 relative to the second side surface C2. Also, the second side surface C2 is closer to the second side plate S2 relative to the first side surface C1. Both the first side surface C1 and the second side surface C2 of the storage board 32 are pluggably connected to the plurality of storage devices 33, to enable the storage board 32 to be the double-sided storage board.

Based on this, the storage board 32 may be fixed in the middle of the pull-push bracket 31, and the storage board 32 is vertically disposed in the pull-push bracket 31. In this case, a length of the storage board 32 may be configured to extend in the Y-axis direction, and a width of the storage board 32 may be configured to extend in the Z-axis direction, so that the storage board 32 is vertically disposed in the push-pull bracket 31.

Since the storage board 32 in the server 100 provided in some embodiments of the present application may be a double-sided storage board, the plurality of storage devices 33 may be disposed on opposite sides of the storage board 32, and are pluggably connected to the storage board 32. That is, the storage devices 33 may be disposed on both sides of the push-pull bracket 31. In this way, plugging directions of the storage devices 33 in the push-pull bracket 31 may be increased, so that the push-pull bracket 31 of the server 100 is available on both sides on the premise of an unchanged specification in a unit space. This, in turn, allows for more space inside the chassis 10 to accommodate the storage devices 33, thereby achieving a high-density storage server.

And, when the storage devices 33 need to be maintained, a storage device 33 that is closer to the first side plate S1 may be plugged in and out along a direction toward the first side plate S1; and a storage device 33 that is closer to the second side plate S2 may be plugged in and out along a direction toward the second side plate S2. That is, there is no obstruction in the Z-axis direction of the storage devices 33, which is more convenient for plugging operations on the storage devices 33, thereby improving the maintenance efficiency of the server by the staff.

In addition, when the server 100 includes a plurality of storage modules 30, a push-pull bracket 31 of each storage module 30 may be pulled out separately. That is, only one push-pull bracket 31 is pulled out each time, and the storage devices 33 on the push-pull bracket 31 are maintained, which can prevent other adjacent push-pull brackets 31 from obstructing plugging operation of the storage devices 33, and facilitate directly performing plugging operations on the storage devices 33, thereby enhancing the maintenance efficiency of the server by the staff. Alternatively, two adjacent push-pull brackets 31 in the server 100 can be configured not to be pulled out simultaneously. That is, a large gap can be maintained between push-pull brackets 31 that are pulled out simultaneously. This ensures that there is sufficient space on one side of a storage device 33 to be plugged away from the storage board 32, allowing for plugging operations on the storage device 33, and preventing other push-pull brackets 31 from obstructing the plugging operation of the storage device 33, thereby enhancing the maintenance efficiency of the server by the staff.

In some examples, each storage device 33 may include a first interface, and the storage board 32 may include a plurality of second interfaces corresponding to first interfaces of the storage devices 33. That is, one storage device 33 may be plugged into one second interface on the storage board 32 via its first interface, thereby achieving an electrical connection between the storage device 33 and the storage board 32. In some embodiments of the present application, a quantity of second structures on the storage board 32 is not limited. That is, a quantity of storage devices 33 pluggably connected on the storage board 32 is not limited in some embodiments of the present application.

In some examples, the first side surface C1 of the storage board 32 includes a plurality of second interfaces, and the second side surface C2 of the storage board 32 also includes a plurality of second interfaces.

In some examples, a quantity of the second interfaces on the first side surface C1 may be equal to a quantity of the second interfaces on the second side surface C2. It is understandable that, in other examples, the quantity of the second interfaces on the first side surface C1 may not be equal to the quantity of the second interfaces on the second side surface C2. In some embodiments of the present application, the quantities of the second interfaces on the first side C1 and the second side C2 of the storage board 32 are not limited.

In summary, the server 100 in some embodiments of the present application may include at least one storage module 30. In each storage module 30, the storage board 32 may be disposed in the middle of the push-pull bracket 31, so that a plurality of storage devices 33 are disposed on opposite sides of the storage board 32, and are pluggably connected to the storage board 32. In this way, plugging directions of the storage devices 33 in the push-pull bracket 31 can be increased, so that the push-pull bracket 31 of the server 100 is available on both sides on the premise of an unchanged specification in a unit space. This, in turn, allows for more space inside the chassis 10 to accommodate the storage devices 33, thereby achieving a high-density storage server. In addition, when the storage devices 33 need to be maintained, any one push-pull bracket 31 can be directly pulled out of the chassis 10 in the Y-axis direction, and then the storage devices 33 can be directly taken out in a ±X-axis direction (the storage devices 33 can be directly taken out in a direction away from the storage board 32) for maintenance of the storage devices 33. After maintenance, the push-pull bracket 31 is pushed into the chassis 10, which facilitates directly performing plugging operations on the storage devices 33, thereby improving the maintenance efficiency of the server by the staff.

In some embodiments, as shown in FIGS. 1 and 2, a quantity of the storage modules 30 in the server 100 is a plurality, and the plurality of storage modules 30 are arranged in a first direction. The first direction is parallel to plugging directions of the storage devices 33. The first direction is also parallel to the X-axis direction.

The server 100 is configured to include a plurality of storage modules 30, so that the storage devices 30 inside the chassis 10 can accommodate more storage devices 33, to achieve a high-density storage server.

Since the server 100 accommodates a greater quantity of storage devices 33, a large amount of heat is generated inside the server 100 during normal operation. The heat cannot be dissipated in confined space, causing temperature inside the server 100 to continuously rise. This easily leads to damage to the storage devices 33, thereby affecting quality of the storage devices 33. Further, the server 100 needs to be cooled by cool air, to prevent internal temperature of the server 100 from becoming too high, thereby affecting the quality of the storage devices 33.

Thus, the cool air can be discharged into the interior of the server 100 at a position of the opening 11, facilitating heat dissipation for the server 100. However, a path of the cool air entering from the opening 11 is as follows: the opening 11, a first column of storage devices, a second column of storage devices, a third column of storage devices, ... an nth column of storage devices. Based on this, when the cool air enters the first column of storage devices and absorbs heat from the first column of storage devices, the cool air will rise to a certain extent. The heated cool air then enters the second column of storage devices, to dissipate heat from the second column of storage devices, and the temperature of the heated cool air will rise again. The reheated cool air further enters the third column of storage devices, to dissipate heat from the third column of storage devices, and so on until the nth column of storage devices. When the cool air is transferred to subsequent columns of storage devices, temperature of the cool air has risen to a certain extent, making it unable to cool a subsequent storage device effectively. This results in a lower heat dissipation effect for the server 100.

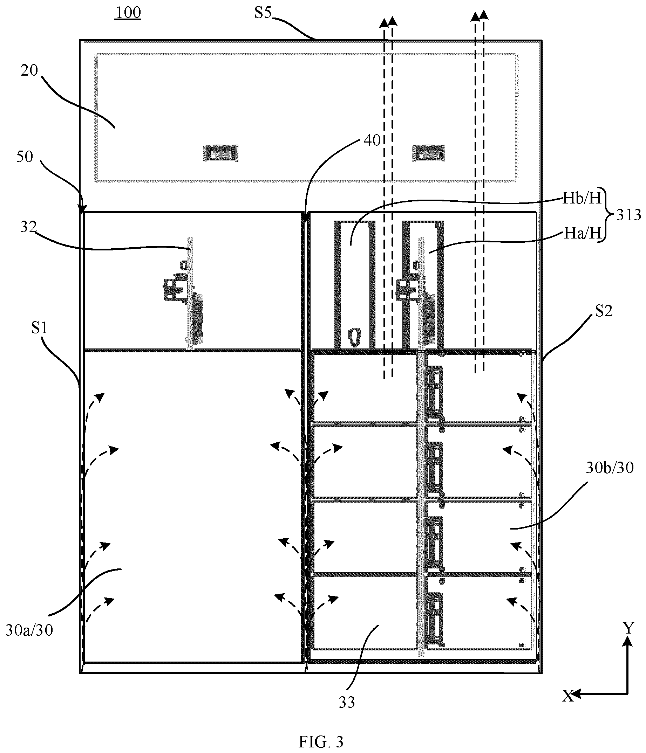

FIG. 3 is a top view of a server according to some embodiments of the present application.

In some embodiments of the present application, the server 100, as shown in FIG. 3, is configured that a first air flow gap 40 is formed between two adjacent storage modules 30.

Based on this, there are two paths of the cooling air entering through the opening 11: in a first path (as shown in the arrow flowing through the first air flow gap 40), the cool air flows through the first air flow gap 40, and enters adjacent storage devices 33 through the first air flow gap 40, to dissipate heat from each storage device 33. Specifically, the cool air flowing through the first air flow gap 40 may respectively enter two storage modules 30 adjacent to the first air flow gap 40, to dissipate heat from each storage device 33 in the two storage modules 30. Since the cool air directly acts on each storage device 33 without being affected by temperature of other storage devices 33, it helps improve the heat dissipation effect of the cool air on each storage device 33, thereby enhancing the heat dissipation effect and the heat dissipation efficiency of the server 100.

A second path is as above: the opening 11, the first column of storage devices, the second column of storage devices, the third column of storage devices, ... the nth column of storage devices. A specific heat dissipation process is consistent with the above description, and will not be repeated here.

Since the first air flow gap 40 on the first path is unobstructed, cool air can preferentially enter the first air flow gap 40. Based on the first air flow gap 40, heat dissipation is performed on adjacent storage devices 33. That is, most of the cool air preferentially enters the first air flow gap 40. Of course, there is also a small amount of residual cool air that dissipates heat from each storage device 33 through the second path.

Some embodiments of the present application do not limit the cool air that flows through the second path, as long as part of the cool air can directly act on each storage device 33 through the first path, which improves the heat dissipation effect of the cool air on each storage device 33, thereby improving the heat dissipation effect and the heat dissipation efficiency of the server 100.

In some embodiments, as shown in FIG. 3, a width of the first air flow gap 40 in the first direction is greater than or equal to 4 mm. That is, in the X-axis direction, the width of the first air flow gap 40 between two adjacent storage modules 30 is greater than or equal to 4 mm. The first direction is also parallel to the X-axis direction.

When the width of the first air flow gap 40 in the first direction is equal to or approaches 4 mm, sufficient cool air may flow through the first air flow gap 40 and dissipate heat from adjacent storage devices 33, thereby enhancing the heat dissipation effect of the cool air on each storage device 33. Since the width of the first air flow gap 40 is relatively small, the first air flow gap 40 may occupy less internal space of the chassis 10, thereby providing sufficient space in the chassis 10 for accommodating a plurality of storage modules 30.

In some embodiments, as shown in FIG. 3, the width of the first air flow gap 40 in the first direction is less than or equal to 12 mm. That is, in the X-axis direction, the width of the first air flow gap 40 between two adjacent storage modules 30 is less than or equal to 12 mm. The first direction is also parallel to the X-axis direction.

When the width of the first air flow gap 40 in the first direction is equal to or approaches 12 mm, space requirements for placing the plurality of storage modules 30 in the chassis 10 can be satisfied. Since the width of the first air flow gap 40 is relatively large, sufficient cool air is allowed to flow through the first air flow gap 40 and dissipate heat from adjacent storage devices 33, thereby better enhancing the heat dissipation effect of the cool air on each storage device 33.

In some embodiments, a width range of the first air flow gap 40 in the first direction is 4 mm~12 mm. With this configuration, the width of the first air flow gap 40 is neither too large nor too small, which can better improve the heat dissipation effect of the cool air on each storage device 33 on the basis of preventing occupying excessive space in the chassis 10.

In some embodiments, the width of the first air flow gap 40 in the first direction is less than or equal to 6 mm. That is, in the X-axis direction, the width of the first air flow gap 40 between two adjacent storage modules 30 is less than or equal to 6 mm.

When the width of the first air flow gap 40 in the first direction is equal to or approaches 6 mm, space requirements for placing the plurality of storage modules 30 in the chassis 10 can be satisfied. Since the width of the first air flow gap 40 is relatively large but not too large, sufficient cool air is allowed to flow through the first air flow gap 40 and dissipate heat from adjacent storage devices 33, thereby better enhancing the heat dissipation effect of the cool air on each storage device 33.

In some embodiments, a width range of the first air flow gap 40 in the first direction is 4 mm~6 mm. That is, in the X-axis direction, a width range of the first air flow gap 40 between two adjacent storage modules 30 is 4 mm~6 mm.

This configuration can better prevent the first air flow gap 40 from occupying too much space in the chassis 10 on the basis of enhancing the heat dissipation effect of the cool air on each storage device 33, thereby providing sufficient space in the chassis 10 for placing the plurality of storage modules 30.

In some examples, the width of the first air flow gap 40 in the first direction may be any one of 4 mm, 5 mm, 6 mm, 7 mm, 8 mm, 9 mm, 10 mm, 11 mm or 12 mm. However, in some embodiments of the present disclosure, the width of the first air flow gap 40 in the first direction is not limited here.

In some embodiments, as shown in FIG. 3, in the first direction, a second air flow gap 50 is included between the storage modules 30 and the chassis 10. The first direction is parallel to plugging directions of the storage devices 33. The first direction is also parallel to the X-axis direction.

The second air flow gap 50 is disposed between the storage modules 30 and the chassis 10. The heat dissipation principle of the second air flow gap 50 is similar to that of the first air flow gap 40. The second air flow gap 50 also includes following two cool air paths. In a first path, cool air flows through the second air flow gap 50, and enters adjacent storage modules 33 through the second air flow gap 50, to dissipate heat from each storage module 33. Since the cool air directly acts on each storage device 33 without being affected by temperature of other storage devices 33, it helps improve the heat dissipation effect of the cool air on each storage device 33, thereby enhancing the heat dissipation effect and the heat dissipation efficiency of the server 100.

A second path is as above: the opening 11, the first column of storage devices, the second column of storage devices, the third column of storage devices, ... the nth column of storage devices. A specific heat dissipation process is consistent with the above description, and will not be repeated here.

Since the second air flow gap 50 on the first path is unobstructed, the cool air can preferentially enter the second air flow gap 50. Based on the second air flow gap 50, heat dissipation is performed on the adjacent storage devices 33. That is, most of the cool air preferentially enters the second air flow gap 50. Of course, there is also a small amount of residual cool air that dissipates heat from each storage device 33 through the second path.

Some embodiments of the present application do not limit the cool air that flows through the second path, as long as part of the cool air can directly act on each storage device 33 through the first path, which improves the heat dissipation effect of the cool air on each storage device 33, thereby improving the heat dissipation effect and the heat dissipation efficiency of the server 100.

In some examples, taking the server 100 including only one storage module 30 for example, there is a second air flow gap 50 between a side surface of the storage module 30 close to the first side plate S1 and the first side plate S1, and there is a second air flow gap 50 between a side surface of the storage module 30 close to the second side plate S2 and the second side plate S2.

In other examples, as shown in FIG. 3, taking the server 100 including 2 storage modules 30 for example, a storage module 30 closer to the first side plate S1 in the 2 storage modules 30 is a first storage module 30a, and a storage module 30 closer to the second side plate S2 in the 2 storage modules 30 is a second storage module 30b.

There is a second air flow gap 50 between a side surface of the storage module 30a close to the first side plate S1 and the first side plate S1. There is a second air flow gap 50 between a side surface of the second storage module 30b closer to the second side plate S2 and the second side plate S2.

In addition, there is a first air flow gap 40 between the first storage module 30a and the second storage module 30b. That is, in this case, the server 100 includes the first air flow gap 40 and the second air flow gap 50. Therefore, the server 100 has beneficial effects of the above first air flow gap 40 and the second air flow gap 50, which will not be repeated here.

In yet other examples, taking the server 100 including 3 storage modules 30 for example, the 3 storage modules 30 are respectively a first storage module, a second storage module, and a third storage module. A storage module 30 closest to the first side plate S1 among the 3 storage modules 30 is the first storage module. A storage module 30 closest to the second side plate S2 among the three storage modules 30 is the second storage module, and the second storage module is located between the first storage module and the second storage module.

There is a second air flow gap 50 between a side surface of the first storage module close to the first side plate S1 and the first side plate S1. And, there is also a second air flow gap 50 between a side surface of the second storage module close to the second side plate S2 and the second side plate S2.

In addition, there is a first air flow gap 40 between a surface of the third storage module close to the first storage module and a surface of the first storage module close to the third storage module. Also, there is a first air flow gap 40 between a surface of the third storage module close to the second storage module and a surface of the second storage module close to the third storage module.

Understandably, when the server includes more than 3 storage modules 30, it is similar to the above, and in combination with the description of the 3 storage modules 30, the difference lies in addition of a corresponding first air flow gap 40.

In some embodiments, as shown in FIG. 3, a width of the second air flow gap 50 in the first direction is greater than or equal to 4 mm. The first direction is parallel to the X-axis direction. That is, in the X-axis direction, a width of a second air flow gap 50 between a surface of the storage module 30 closest to the first side plate S1 of the chassis 10, which is close to one side of the first side plate S1, and the first side plate S1, is greater than or equal to 4 mm. Alternatively, in the X-axis direction, a width of a second air flow gap 50 between a surface of the storage module 30 closest to the second side plate S2 of the chassis 10, which is close to the second side plate S2, and the second side plate S2, is greater than or equal to 4 mm.

When the width of the second air flow gap 50 in the first direction is equal to or approaches 4 mm, sufficient cool air may flow through the second air flow gap 50 and dissipate heat from the adjacent storage devices 33, thereby enhancing the heat dissipation effect of the cool air on each storage device 33. Since the width of the first second flow gap 50 is relatively small, the second air flow gap 50 may occupy less internal space of the chassis 10, thereby providing sufficient space in the chassis 10 for accommodating the plurality of storage modules 30.

In some embodiments, as shown in FIG. 3, a width of the second air flow gap 50 in the first direction is less than or equal to 6 mm. The first direction is parallel to the X-axis direction. That is, in the X-axis direction, a width of a second air flow gap 50 between a surface of the storage module 30 closest to the first side plate S1 of the chassis 10, which is close to one side of the first side plate S1, and the first side plate S1, is less than or equal to 6 mm. Alternatively, in the X-axis direction, a width of a second air flow gap 50 between a surface of the storage module 30 closest to the second side plate S2 of the chassis 10, which is close to the second side plate S2, and the second side plate S2, is less than or equal to 6 mm.

When the width of the second air flow gap 50 in the first direction is equal to or approaches 6 mm, space requirements for placing the plurality of storage modules 30 in the chassis 10 can be satisfied. Since the width of the second air flow gap 50 is relatively large, sufficient cool air is allowed to flow through the second air flow gap 50 and dissipate heat from the adjacent storage devices 33, thereby better enhancing the heat dissipation effect of the cool air on each storage device 33.

In some embodiments, as shown in FIG. 3, a width range of the second air flow gap 50 in the first direction is 4 mm~6 mm. With this configuration, the width of the first air flow gap 40 is neither too large nor too small, which can better improve the heat dissipation effect of the cool air on each storage device 33 on the basis of preventing occupying excessive space in the chassis 10.

In some examples, the width of the second air flow gap 50 in the first direction may be any one of 4 mm, 5 mm or 6 mm. However, in some embodiments of the present disclosure, the width of the second air flow gap 50 in the first direction is not limited here.

In some embodiments, as shown in FIG. 2 in combination with FIG. 3, along a push-pull direction of the storage module 30, the chassis 10 includes a side plate S5 opposite to the opening 11. The side plate S5 includes a plurality of heat dissipation holes T.

The push-pull direction of the storage module 30 is parallel to the Y-axis direction. In the Y-axis direction, the chassis 10 includes the side plate S5 opposite to the opening 11. The side plate S5 is a third side plate S5 of the chassis 10. The third side plate S5 is provided with a plurality of heat dissipation holes T.

With this configuration, the cool air enters the server 100 through the opening 11. After the cool air dissipates heat from each storage device 33 in the server 100, temperature of the cool air rises. The heated cool air may flow out of the heat dissipation holes T. Based on this, heat dissipation of each storage device 33 in the server 100 is completed.

Some embodiments of the present application do not limit a quantity and a shape of the heat dissipation hole T on the side plate S5, which may be configured according to the actual situation. For example, the shape of the heat dissipation hole T may be circular, square, triangular, etc. FIG. 2 is illustrated by taking the shape of the heat dissipation hole T being circular for example.

In some embodiments, as shown in FIG. 2 in combination with FIG. 3, in the Y-axis direction, the heat dissipation hole T at least partially overlaps with the storage device 33, and the heat dissipation hole T does not overlap with the second air flow gap 50. On the basis of the server 100 having the first air flow gap 40, the heat dissipation hole T may not overlap with the first air flow gap 40 in the Y-axis direction.

The heat dissipation hole T is disposed to at least partially overlap with the storage device 33, so that air that has dissipated heat from the storage device 33 can be directly transferred to the exterior of the chassis 10 through the heat dissipation hole T, which reduces a path of the cool air, and prevents the heated cool air from flowing in the chassis 10, thereby affecting the heat dissipation efficiency. In the Y-axis direction, the heat dissipation hole T does not overlap with the second air flow gap 50. This prevents the cool air from being directly transferred to the exterior of the chassis 10 through the heat dissipation hole T without first dissipating heat from the storage device 33 through the second air gap 50, thereby improving a utilization rate of the cool air and enhancing a heat dissipation effect of each storage device 33 in the server 100. In the Y-axis direction, the heat dissipation hole T does not overlap with the first air flow gap 40. Based on the same principle, this prevents the cool air from being directly transferred to the exterior of the chassis 10 through the heat dissipation hole T without first dissipating heat from the storage device 33 through the first flow air gap 40, thereby improving the utilization rate of the cool air and enhancing the heat dissipation effect of each storage device 33 in the server 100.

The above describes various components in the server 100, as well as a spacing between the components. The following specifically introduces a specific structure of the storage module 30 in the server 100, in combination with the accompanying drawings.

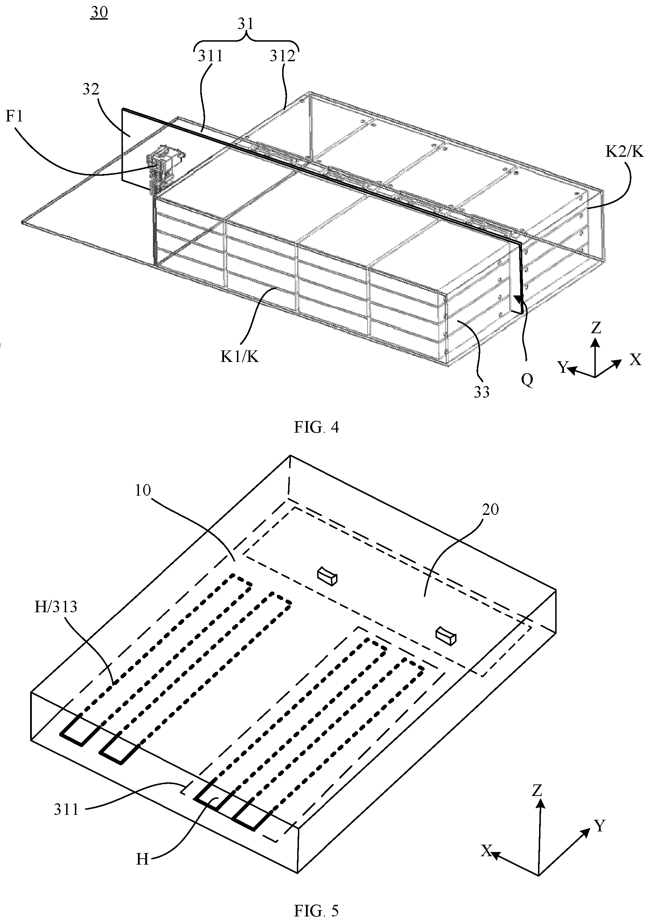

FIG. 4 is a structural diagram of a heat dissipation module in FIG. 2.

In some embodiments, as shown in FIG. 4, the push-pull bracket 31 in the storage module 30 includes a support plate 311 and a cage 312, and the cage 312 is located on one side of the support plate 311. The cage 312 includes a mounting position Q, and the storage board 32 is mounted in the mounting position Q. The cage 312 may also include a plurality of plugging slots K. The plurality of plugging slots K are disposed on opposite sides of the mounting position Q, to enable the storage devices 33 to be plugged into the plugging slots K and electrically connected to the storage board 32.

Based on this, the storage board 32 is mounted in the mounting position Q. That is, the storage board 32 is mounted in the cage 312. Furthermore, space on both sides of the storage board 32 in the cage 312 may be used for placing the storage devices 33. Based on this, the plurality of storage devices 33 may be disposed on opposite sides of the storage board 32. In this way, the plugging directions of the storage devices 33 in the push-pull bracket 31 can be increased, so that the push-pull bracket 31 of the server 100 is available on both sides on the premise of an unchanged specification in a unit space. This, in turn, allows for more space inside the chassis 10 to accommodate the storage devices 33, thereby achieving a high-density storage server.

In some examples, as shown in FIG. 4 and in combination with FIG. 2, a plugging slot K located on one side of the mounting position Q close to the first side plate S1 is a first plugging slot K1, and the plugging slot K located on one side of the mounting position Q close to the second side plate S2 is a second plugging slot K2.

In the X-axis direction, there is a gap between the first plugging slot K1 and the second plugging slot K2 that are arranged adjacent to each other, which is used to form the mounting position Q. Based on this, the cage 312 can be divided into two storage spaces, thereby increasing space for placing the storage devices 33 in the cage 312.

Specifically, a part of storage devices of the plurality of storage devices 33 may be plugged into the first plugging slot K1 in a direction from the first side plate S1 toward the mounting position Q, and electrically connected to the storage board 32 in a pluggable manner. Another part of storage devices of the plurality of storage devices 33 may be plugged into the second plugging slot K2 in a direction from the mounting position Q toward the second side plate S2, and electrically connected to the storage board 32 in a pluggable manner.

Based on this, the storage devices 33 may be plugged into the plugging slots K in different directions and electrically connected to the storage board 32, so that insertion directions of the storage devices 33 in the push-pull bracket 31 may be increased, and the push-pull bracket 31 of the server 100 is available on both sides on the premise of an unchanged specification in a unit space. This, in turn, allows for more space inside the chassis 10 to accommodate the storage devices 33, thereby achieving a high-density storage server.

FIG. 5 is an assembly diagram of a slide rail assembly and a chassis in FIG. 3. To better illustrate a position of the slide rail assembly 313 in the server 100, FIG. 5 also illustrates the system board 20 in the chassis 10.

In some embodiments, as shown in FIG. 5 and in combination with FIG. 3, the push-pull bracket 31 also includes a slide rail assembly 313. The slide rail assembly 313 is located between one side surface of the support plate 311 facing away from the cage 312 and the chassis 10.

The push-pull bracket 31 also includes the slide rail assembly 313, and the slide rail assembly 313 is extendable in the Y-axis direction, allowing the storage module 30 to be slidably connected to the chassis 10 through the push-pull bracket 31. This enables the storage module 30 to be pushed into the first accommodation space 12 from the opening 11, or pulled from the first accommodation space 12 to one side of the opening 11 away from the first accommodation space 12.

That is, the slide rail assembly 313 allows the push-pull bracket 31 to reciprocate in the Y-axis direction in the chassis 10. When the server 100 is in a normal operating condition, the slide rail assembly 313 is used to place the push-pull bracket 31 in the first accommodation space 12 in the chassis 10. When the storage devices 33 in the server 100 need to be maintained, the push-pull bracket 31 may be pulled out of the chassis 10 by using the slide rail assembly 313 (the push-pull bracket 31 may be pulled from the first accommodation space 12 to the exterior of the chassis 10 in the direction from the third side plate S5 toward the opening 11), and then the storage devices 33 on the push-pull bracket 31 may be pulled out in the Y-axis direction for maintenance of the storage devices 33, thereby improving the maintenance efficiency of the server by the staff.

The slide rail assembly 313 is located between one side surface of the support plate 311 facing away from the cage 312 and the chassis 10. The following two cases may be included:

In a first case, the slide rail assembly 313 is located between one side surface of the support plate 311 facing away from the cage 312 and the bottom plate S4.

In a second case, the slide rail assembly 313 is located between one side surface of the support plate 311 facing away from the cage 312 and the top plate S3.

In summary, in the above two cases, the slide rail assembly 313 is disposed at both ends of the push-pull bracket 31 in the Z-axis direction. With this configuration, the slide rail assembly 313 can be prevented from occupying one side surface of the push-pull bracket 31 in the X-axis direction, so that the storage devices 33 are disposed on both sides of the push-pull bracket 31 in the X-axis direction, and the slide rail assembly 313 does not affect the plugging of the storage devices 33. Therefore, insertion directions of the storage devices 33 in the push-pull bracket 31 can be increased, so that the push-pull bracket 31 of the server 100 is available on both sides on the premise of an unchanged specification in a unit space. This, in turn, allows for more space inside the chassis 10 to accommodate the storage devices 33, thereby achieving a high-density storage server.

In summary, in the above two manners, the slide rail assembly 313 is disposed at both ends of the push-pull bracket 31 in the Z-axis direction. The configuration also prevents the slide rail assembly 313 from affecting sizes of the first air flow gap 40 and the second air flow gap 50 when the slide rail assembly 313 is disposed at both ends of the push-pull bracket 31 in the X-axis direction, and prevents the slide rail assembly 313 from blocking transfer of cool air in the first air flow gap 40 and the second air flow gap 50, which is conducive to improving the heat dissipation effect of each storage device 33 in the server 100.

In some embodiments, as shown in FIG. 5 and in combination with FIG. 3, the slide rail assembly 313 includes at least one telescopic slide rail H. The support plate 311 can be driven to slide in the chassis 10 by using the telescopic slide rail H, so that the storage module 30 slides in the chassis 10 by the push-pull bracket 31 and the storage module can be pushed into the first accommodation space 12 through the opening 11. With this configuration, friction when the push-pull bracket 31 slides in the chassis 10 can be reduced, which allows the push-pull bracket 31 to be pulled out of the chassis 10 in the Y-axis direction and the storage devices 33 to be directly taken out in the X-axis direction for maintenance of the storage devices 33. That is, it is more convenient to perform plugging operations on the storage devices 33, thereby improving the maintenance efficiency of the server 100 by the staff.

In some examples, the slide rail assembly 313 may include two telescopic slide rails H. The two telescopic slide rails H are spaced on one side of the support plate 311 away from the cage 312. The force acting on the slide rail assembly 313 can be distributed, thereby allowing for a better fixed connection with the support plate 311, and preventing the support plate 311 from swaying left and right during reciprocation (left and right refer to deflection toward one side of the first side plate S1 or toward one side of the second side plate S2). This facilitates improving stability of the support plate 311 during its movement, and facilitates improving stability of the storage module 30 during its movement.

In some embodiments of the present disclosure, positions of the two telescopic slide rails H in the slide rail assembly 313 are not limited. For example, the two telescopic slide rails H are respectively a first telescopic slide rail Ha and a second telescopic slide rail Hb. The first telescopic slide rail Ha may be arranged to overlap with the storage board 32 in the Z-axis direction, and the second telescopic slide rail Hb may be arranged at a position closer to the first side plate S1 relative to the first telescopic slide rail Ha.

It is understandable that, in some other examples, the first telescopic slide Ha and the second telescopic slide Hb are respectively arranged at positions of two sides of the support plate 311 in the X-axis direction, which are not limited in some embodiments of the present disclosure.

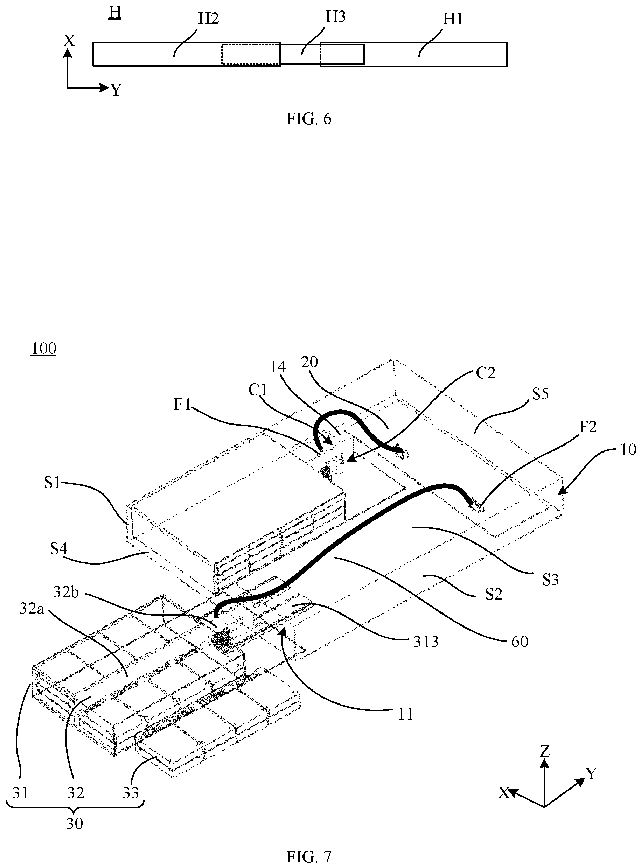

FIG. 6 is a structural diagram of a telescopic slide rail in the slide rail assembly in FIG. 3.

In some embodiments, as shown in FIG. 6 and in combination with FIG. 3, the slide rail assembly 313 includes at least one telescopic slide rail H. The telescopic slide rail H includes a first fixed slide rail H1, a connecting slide rail H3, and a second fixed slide rail H2. One side of the first fixed slide rail H1 is fixedly connected to the chassis 10, and the other side of the first fixed slide rail H1 is slidably connected to the connecting slide rail H3. One side of the second fixed slide rail H2 is fixedly connected to the support plate 311, and the other side of the second fixed slide rail H2 is slidably connected to the connecting slide rail H3.

The slide rail assembly 313 includes at least one telescopic slide rail H. The telescopic slide rail H includes a first fixed slide rail H1, a connecting slide rail H3, and a second fixed slide rail H2. The first fixed slide rail H1 of the telescopic slide rail H is fixedly connected to the chassis 10, and the second fixed slide rail H2 of the telescopic slide rail H is fixedly connected to the support plate 311. The support plate 311 can be driven to slide in the chassis 10 through relative movement of the first fixed slide rail H1 and the second fixed slide rail H2, so that the storage module 30 slides in the chassis 10 by the push-pull bracket 31, and the storage module 30 can be pushed into the first accommodation space 12 through the opening 11. With this configuration, friction when the push-pull bracket 31 slides in the chassis 10 can be reduced, which allows the push-pull bracket 31 to be pulled out of the chassis 10 in the Y-axis direction and the storage devices 33 to be directly taken out in the X-axis direction for maintenance of the storage devices 33. That is, it is more convenient to perform plugging operations on the storage devices 33, thereby improving the maintenance efficiency of the server 100 by the staff.

In addition, since the first fixed slide rail H1 and the second fixed slide rail H2 are slidably connected by the connecting slide rail H3, the second fixed slide rail H2 extends out a greater distance, which in turn allows the push-pull bracket 31 to slide out further. This facilitates pulling out the push-pull bracket 31 from the chassis 10. Further, it is more convenient to perform plugging operations on the storage devices 33, which is conductive to improving the maintenance efficiency of the server 100 by the staff.

Based on this, the first fixed slide rail H1 is provided with a first limiting structure on both ends for preventing the connecting slide rail H3 from detaching. The first limiting structure blocks both ends of the first fixed slide rail H1, which allows the first fixed slide rail H1 and the connecting slide rail H3 to slide relative to each other. However, the connecting slide rail H3 remains attached to the first fixed slide rail H1, ensuring stability of the telescopic slide rail H.

The second fixed slide rail H2 is provided with a second limiting structure on both ends thereof for preventing the connecting slide rail H3 from detaching. The second limiting structure blocks both ends of the second fixed slide rail H2, which allows the second fixed slide rail H2 and the connecting slide rail H3 to slide relative to each other. However, the connecting slide rail H3 remains attached to the second fixed slide rail H2, ensuring the stability of the telescopic slide rail H.

In some examples, the first limiting structure may be a metal block, and is disposed at both ends of the first fixed slide rail H1 and fixedly connected to the both ends of the first fixed slide rail H1. The first limiting structure may be used to prevent the first fixed slide rail H1 and the connecting slide rail H3 from coming off a track.

In some examples, the second limiting structure may be a metal block, and is disposed at both ends of the second fixed slide rail H2 and fixedly connected to the both ends of the second fixed slide rail H2. The second limiting structure may be used to prevent the second fixed slide rail H2 and the connecting slide rail H3 from coming off the track.

FIG. 7 is a structural diagram of a server according to yet other embodiments of the present application.

In some embodiments, as shown in FIG. 7, the server 100 also includes a cable 60. One end of the cable 60 is electrically connected to the system board 20, and the other end of the cable 60 is electrically connected to the storage board 32. Based on this, the system board 20 may transmit a signal to the storage card 32 via the cable 60.

In some examples, the storage board 32 includes a first connector F1 (which may refer back to FIG. 4). The system board 20 includes a second connector F2. One end of the cable 60 is electrically connected to the first connector F1, and the other end of the cable 60 is electrically connected to the second connector F2, so that the storage board 32 is electrically connected to the system board 20. However, in some embodiments of the present application, models of the first connector F1 and the second connector F2 are not limited, as long as it is ensured that the storage board 32 is electrically connected to the system board 20 for signal transmission.

In some examples, the cable 60 may be a flexible cable. The flexible cable refers to a cable that can be bent or deformed and is flexible, which ensures that when the push-pull bracket 31 reciprocates in the Y-axis direction, that is, when the push-pull bracket 31 is pushed in a direction facing away from the system board 20 (a direction from the second accommodation space 13 toward the first accommodation space 12), the flexible cable changes from one deformation state to another. Since the cable is flexible, the deformation does not impede movement of the push-pull bracket 31. Also, when the push-pull bracket 31 is pushed in a direction close to the system board 20 (in a direction from the first accommodation space 12 toward the second accommodation space 13), the flexible cable restores to its previous deformation state. However, in whatever configuration, the flexible cable can be used for signal transmission.

In some examples, the chassis 10 also includes a third accommodation space 14. The third accommodation space 14 is located between the first accommodation space 12 and the second accommodation space 13; the third accommodation space 14 is used for storing the cable 60.

When the push-pull bracket 31 is pushed in the direction facing away from the system board 20 (in the direction from the second accommodation space 13 toward the first accommodation space 12), the cable 60 can extend from the third accommodation space 14 to the first accommodation space 12. This ensures that when the push-pull bracket 31 is pulled out of the chassis 10, the system board 20 and the storage board 32 can still maintain an electrical connection. When the push-pull bracket 31 is pushed in the direction close to the system board 20 (in the direction from the first accommodation space 12 toward the second accommodation space 13), the cable 60 can retract into the third accommodation space 14, and be stored in the third accommodation space 14. This ensures that storage space of the system board 20 located in the second accommodation space 13 and storage space of the storage module 30 located in the first accommodation space 12 are not affect. Furthermore, the push-pull bracket 31 can slide in the chassis 10 more flexibly.

In some embodiments, as shown in FIG. 7, in the Y-axis direction, the storage board 32 includes a first part 32a and a second part 32b, and the second part 32b is closer to the system board 20 relative to the first part 32a. The first part 32a of the storage board 32 is located between the first plugging slot K1 and the second plugging slot K2. That is, in the X-axis direction, the first part 32a overlaps with the cage 312. The second part 32b of the storage board 32 protrudes from the cage 312 in the Y-axis direction. That is, in the X-axis direction, the second part 32b does not overlap with the cage 312.

Based on this, the first part 32a is configured to be pluggably connected to a plurality of storage devices 33, and the second part 32b of the storage board 32 is configured to be electrically connected to the system board. The second part 32b is closer to the system board 20 relative to the first part 32a, thereby eliminating the need for the first part 32a to reserve additional space for electrical connection to the system board 20. This configuration also facilitates a pluggable connection between the first part 32a and the plurality of storage devices 33. At the same time, the second part 32b closer to one side of the system board 20 is configured electrically connected to the system board 20, that is, the second part 32b is electrically connected to the system board 20 by the cable 60. A position of the second part 32b facilitates accommodation of the cable 60, preventing the cable 60 from obstructing sliding of the push-pull bracket 31 in the chassis 10.

For example, the first connector on the storage board 32 may be located on the second part 32b. Based on this, it is convenient to accommodate the cable 60, thereby preventing the cable 60 from obstructing sliding of the pull-push racket 31 in the chassis 10.

The above descriptions are only embodiments of the present application, but the protection scope of the present application is not limited here. Any changes or substitutions conceived by those skilled in the art within the technical scope disclosed in the present application shall fall within the protection scope of the present application. Therefore, the protection scope of the present application shall be subject to the protection scope of the claims.

## Claims

1. A server, comprising: a chassis, a system board, and at least one storage module;
wherein the chassis comprises an opening; the chassis comprises a first accommodation space and a second accommodation space, and the first accommodation space is closer to the opening relative to the second accommodation space;
the system board is located in the second accommodation space;
the storage module comprises a push-pull bracket, a storage board, and a plurality of storage devices; the storage board is secured in the push-pull bracket, and is electrically connected to the system board; and the plurality of storage devices are disposed on opposite sides of the storage board, and are pluggably connected to the storage board; and
the storage module is slidably connected to the chassis by the push-pull bracket, to enable the storage module to be pushed into the first accommodation space through the opening.

2. The server according to claim 1, wherein the push-pull bracket comprises a support plate and a cage, and the cage is located on one side of the support plate; the cage comprises a mounting position, and the storage board is mounted in the mounting position;
the cage further comprises a plurality of plugging slots; and the plurality of plugging slots are disposed on opposite sides of the mounting position, to enable the storage devices to be plugged into the plugging slots and electrically connected to the storage board.

3. The server according to claim 2, wherein the push-pull bracket further comprises a slide rail assembly; and the slide rail assembly is located between one side surface of the support plate away from the cage and the chassis.

4. The server according to claim 3, wherein the slide rail assembly comprises at least one telescopic slide rail; the telescopic slide rail comprises a first fixed slide rail, a connecting slide rail, and a second fixed slide rail;
one side of the first fixed slide rail is fixedly connected to the chassis, and the other side of the first fixed slide rail is slidably connected to the connecting slide rail; and the first fixed slide rail is provided with a first limiting structure on both ends thereof configured to prevent the connecting slide rail from detaching; and
one side of the second fixed slide rail is fixedly connected to the support plate, and the other side of the second fixed slide rail is slidably connected to the connecting slide rail; and the second fixed slide rail is provided with a second limiting structure on both ends thereof configured to prevent the connecting slide rail from detaching.

5. The server according to any one of claims 1 to 4, wherein there are a plurality of the storage modules, and the plurality of storage modules are arranged in a first direction; wherein the first direction is parallel to plugging directions of the storage devices; and
a first air flow gap is formed between two adjacent storage modules.

6. The server according to claim 5, wherein a width of the first air flow gap in the first direction is greater than or equal to 4 mm.

7. The server according to claim 5 or 6, wherein a width of the first air flow gap in the first direction is less than or equal to 12 mm.

8. The server according to any one of claims 1 to 7, wherein in a first direction, a second air flow gap is comprised between the storage module and the chassis; wherein the first direction is parallel to plugging directions of the storage devices.

9. The server according to claim 8, wherein a width of the second air flow gap in the first direction is greater than or equal to 4 mm.

10. The server according to any one of claims 1 to 9, further comprising a cable; wherein one end of the cable is electrically connected to the system board, and the other end of the cable is electrically connected to the storage board.

11. The server according to any one of claims 1 to 10, wherein in a push-pull direction of the storage module, the chassis comprises a side plate opposite to the opening; and the side plate comprises a plurality of heat dissipation holes.
